# EUROPÄISCHE PATENTANMELDUNG

(11) **EP 2 525 197 A1**
(43) Veröffentlichungstag der Anmeldung: **21.11.2012**
(21) Anmeldenummer: 12159937.7
(22) Anmeldetag: 16.03.2012
(51) Int. Cl.: G01F 1/692, G01F 15/18

(54) **Vorrichtung zur Erfassung mindestens einer Eigenschaft eines strömenden fluiden Mediums**

(30) Priorität: 20.05.2011 DE 102011076170
(71) Anmelder: Robert Bosch GmbH, 70442 Stuttgart (DE)
(72) Erfinder: Rittmann, Michael, 71254 Ditzingen (DE); Markov, Alexander, 70437 Stuttgart (DE)

(57) **Zusammenfassung**

Es wird eine Vorrichtung (110) zur Erfassung mindestens einer Eigenschaft eines strömenden fluiden Mediums vorgeschlagen. Die Vorrichtung (110) umfasst mindestens einen von dem fluiden Medium durchströmbaren Strömungskanal (126). Weiterhin umfasst die Vorrichtung (110) mindestens ein Elektronik-Modul (134) mit mindestens einer Ansteuer- und Auswerteschaltung (138). Das Elektronik-Modul (134) weist mindestens einen in den Strömungskanal (126) ragenden Sensorträger (144) mit mindestens einem Sensorelement (148) zur Erfassung der Eigenschaft auf. Das Elektronik-Modul (134) weist mindestens ein Trägerelement (136) mit mindestens einem darauf aufgebrachten Schaltungsträger (140) der Ansteuer- und Auswerteschaltung (138) auf. Das Trägerelement (136) weist auf mindestens einer dem Schaltungsträger (140) zuweisenden Oberfläche (158) eine Mehrzahl von Vertiefungen (160) auf.

## Beschreibung

### Stand der Technik

Die Erfindung geht aus von bekannten Vorrichtungen zur Bestimmung mindestens einer Eigenschaft eines strömenden fluiden Mediums. Bei dem fluiden Medium kann es sich grundsätzlich um Gase und/oder Flüssigkeiten handeln, insbesondere um Luft, beispielsweise Ansaugluft in einem Ansaugtrakt einer Brennkraftmaschine eines Kraftfahrzeugs. Auch andere Einsatzgebiete sind jedoch denkbar. Bei der mindestens einen zu bestimmenden Eigenschaft kann es sich grundsätzlich um einen beliebigen physikalischen und/oder chemischen Parameter des fluiden Mediums handeln. Insbesondere kann es sich bei der Eigenschaft um eine Strömungseigenschaft handeln, beispielsweise eine Strömungsgeschwindigkeit und/oder einen Massenstrom und/oder einen Volumenstrom. Die Erfindung wird im Folgenden, ohne Beschränkung weiterer möglicher Ausgestaltungen, insbesondere beschrieben unter Bezugnahme auf eine Luftmassenmessung, beispielsweise im Ansaugtrakt einer Brennkraftmaschine. Aus dem Stand der Technik sind zahlreiche Luftmassenmesser bekannt, beispielsweise aus K. Reif (Hrsg.): Sensoren im Kraftfahrzeug, 1. Auflage 2010, Vieweg + Teubner Verlag, 2010, S. 146-148. Insbesondere kann es sich hierbei um so genannte Heißfilmluftmassenmesser handeln, welche in der Regel als Steckfühler ausgestaltet sind und welche mindestens einen Kanal umfassen, durch welchen ein Teil des strömenden fluiden Mediums geleitet wird. Beispielsweise kann der Steckfühler in ein Strömungsrohr eingebracht werden, und ein Teil des strömenden fluiden Mediums wird durch einen Kanal des Steckfühlers geleitet. In dem Kanal ist üblicherweise ein Sensorelement, beispielsweise ein Heißfilmluftmassenmesserchip, angeordnet, welcher mindestens ein Heizelement und mindestens zwei stromaufwärts und stromabwärts des Heizelements angeordnete Temperaturfühler umfasst. Aus einer Asymmetrie der Temperaturverteilung kann auf einen Massenstrom des fluiden Mediums, beispielsweise der Ansaugluft, geschlossen werden.

Aus DE 103 45 584 A1 ist ein Heißfilm-Luftmassen-Durchflussmesser zur Erfassung des Durchflusses eines strömenden Mediums im Ansaugtrakt oder Ladelufttrakt einer Verbrennungskraftmaschine bekannt. Dabei ist ein einen Sensorchip aufnehmendes Trägerteil vorgesehen, welches einem Kanal, der zumindest von einem Teilmassenstrom des strömenden Mediums durchströmt wird, zugeordnet ist. Der Sensorchip ragt in den von dem Teilmassenstrom strömenden fluiden Mediums durchströmten Kanal hinein. Das Trägerteil des entweder als separat gespritzte Kunststoffzunge oder als einer aus Kunststoffmaterial gespritzt Kaverne ausgebildet. Der Sensorchip ist stromab in Bezug auf eine Anströmrichtung des strömenden Mediums hinter einer Anströmkante liegend integriert.

Bekannte Sensoranordnungen wie beispielsweise die genannten Heißfilmluftmassenmesser weisen üblicherweise einen Sensorträger auf, in welchen der Heißfilmluftmassenmesserchip eingeklebt wird. Der Sensorträger bildet üblicherweise zusammen mit einem Bodenblech aus Metall eine Einheit. Zusätzlich zum Sensor wird üblicherweise noch eine Ansteuer- und Auswerteelektronik auf einer Leiterplatte auf dieses Bodenblech aufgeklebt. Das Sensorelement und die Elektronik werden beispielsweise durch Bondverbindungen miteinander verbunden. Das so entstandene Elektronik-Modul wird üblicherweise in ein Sensorgehäuse eingeklebt, und das Sensorgehäuse, welches beispielsweise als Steckfühler ausgestaltet ist, wird beispielsweise mit Deckeln verschlossen.

Eine technische Herausforderung bei derartigen Sensoren stellt üblicherweise die Verbindung zwischen der Ansteuer- und Auswerteelektronik und dem Bodenblech dar. So ist insbesondere eine ausreichende Adhäsion zwischen dem Bodenblech und dem Schaltungsträger der Ansteuer- und Auswerteelektronik, beispielsweise einer Leiterplatte, nicht in allen Fällen einfach in einer Weise zu realisieren, die eine ausreichende Langzeitstabilität bei gleichzeitigem geringem Fertigungsausschuss gewährleistet.

### Offenbarung der Erfindung

Es wird daher eine Vorrichtung zur Erfassung mindestens einer Eigenschaft eines strömenden fluiden Mediums vorgeschlagen, welche die Nachteile bekannter Vorrichtungen zumindest weitgehend vermeidet. Die Vorrichtung geht grundsätzlich aus von den oben beschriebenen Vorrichtungen, so dass es sich beispielsweise bei dem fluiden Medium um eine oder mehrere Gase und/oder Flüssigkeiten, insbesondere um Luft, beispielsweise um eine Ansaugluftmasse einer Brennkraftmaschine, handeln kann. Bei der mindestens einen qualitativen und/oder quantitativen erfassbaren Eigenschaft des strömenden fluiden Mediums kann es sich insbesondere um eine oder mehrere Strömungseigenschaften handeln, beispielsweise um eine Geschwindigkeit und/oder einen Volumenstrom und/oder einen Massenstrom. Insbesondere kann die Vorrichtung somit als Luftmassenmesser ausgestaltet sein, vorzugsweise für den Einsatz im Ansaugtrakt einer Brennkraftmaschine. Auch andere Ausgestaltungen sind jedoch grundsätzlich möglich.

Die Vorrichtung umfasst mindestens einen von dem fluiden Medium durchströmbaren Strömungskanal. Dieser mindestens eine Strömungskanal kann beispielsweise in einem Gehäuse der Vorrichtung aufgenommen sein, beispielsweise in einem Steckfühlergehäuse eines Steckfühlers der Vorrichtung, wobei der Steckfühler beispielsweise in ein Strömungsrohr, welches von dem strömenden fluiden Medium durchströmt werden kann, einsteckbar oder einbaubar ist, so dass dieser in die Strömung des fluiden Mediums hineinragt. Weiterhin umfasst die Vorrichtung mindestens ein Elektronik-Modul mit mindestens einer Ansteuer- und Auswerteschaltung. Das Elektronik-Modul weist mindestens einen in den Strömungskanal ragenden Sensorträger mit mindestens einem Sensorelement zur Erfassung der Eigenschaft auf, insbesondere einen Heißfilmluftmassenmesserchip. Für mögliche Ausgestaltungen des Heißfilmluftmassenmesserchips kann auf die obige Beschreibung verwiesen werden. Insbesondere kann der Heißfilmluftmassenmesserchip einen Halbleiterchip mit mindestens einer Messoberfläche umfassen, wobei unmittelbar auf der Messoberfläche oder durch eine oder mehrere Schutzschichten geschützt unter der Messoberfläche mindestens ein Heizelement und mindestens zwei aufeinander gegenüberliegenden Seiten des Heizelements angeordnete Temperaturfühler angeordnet sein können, beispielsweise um eine durch die Strömung des fluiden Mediums verursachte Asymmetrie in einer Temperaturverteilung zu erfassen. Das Elektronik-Modul weist mindestens ein Trägerelement mit mindestens einem darauf aufgebrachten Schaltungsträger der Ansteuer- und Auswerteschaltung auf. Das Trägerelement weist auf mindestens einer dem Schaltungsträger zuweisenden Oberfläche eine Mehrzahl von Vertiefungen auf.

Unter einem Sensorelement ist allgemein im Rahmen der vorliegenden Erfindung ein Element zu verstehen, welches eingerichtet ist, um die mindestens eine nachzuweisende Eigenschaft qualitativ und/oder quantitativ zu erfassen und beispielsweise in geeignete Messsignale, insbesondere elektrische und/oder optische Signale umzuwandeln. Insbesondere kann dieses Sensorelement mindestens einen mit dem strömenden fluiden Medium in Kontakt bringbaren Sensorchip umfassen. Beispielsweise kann das Sensorelement mindestens einen Sensorchip mit einer Messoberfläche umfassen, wobei auf der Messoberfläche beispielsweise mindestens ein Heizelement, beispielsweise ein Heizwiderstand, und mindestens zwei Temperaturfühler, beispielsweise zwei Temperaturmesswiderstände, angeordnet sein können. Wie oben dargestellt, kann beispielsweise aus einer Asymmetrie der Temperaturverteilung und/oder der Messsignale der Temperaturfühler auf einen Massenstrom und/oder einen Volumenstrom und/oder auf eine Geschwindigkeit des fluiden Mediums geschlossen werden. Alternativ oder zusätzlich kann das Sensorelement jedoch auch andere Arten von Sensorelementen umfassen, beispielsweise einen oder mehrere Temperaturfühler und/oder Druckfühler und/oder andere Arten von Sensorelementen, welche grundsätzlich aus dem Stand der Technik bekannt sein können. Das Sensorelement kann insbesondere derart in der Vorrichtung aufgenommen sein, dass dieses direkt oder indirekt in Kontakt mit dem strömenden fluiden Medium steht.

Die Vorrichtung kann ganz oder teilweise beispielsweise in einem Strömungsrohr angeordnet sein und/oder kann ein Strömungsrohr umfassen. Beispielsweise kann die Vorrichtung auch ganz oder teilweise als Streckfühler ausgestaltet sein, welcher beispielsweise ein Gehäuse aufweisen kann, das in das strömende fluide Medium hineinragt und/oder einbringbar ist, beispielsweise permanent oder austauschbar. So kann die Vorrichtung beispielsweise ein Strömungsrohr umfassen und/oder mit einem Strömungsrohr zusammenwirken, in welches der Steckfühler hineinragen kann, so dass der Steckfühler in den Strömungsquerschnitt des Strömungsrohrs hineinragt. In dem Steckfühler und/oder in einem Gehäuse des Steckfühlers kann beispielsweise der mindestens eine Strömungskanal aufgenommen sein, durch welchen beispielsweise ein Teilstrom des strömenden fluiden Mediums geleitete werden kann, beispielsweise aus dem Strömungsrohr. Beispielsweise kann der Steckfühler eine Einlassöffnung umfassen, durch welche ein Teil des fluiden Mediums in den Strömungskanal hineingeleitet wird, und mindestens eine Auslassöffnung, durch welche ein Ausströmen aus dem Strömungskanal möglich ist. Der Strömungskanal kann insbesondere verzweigt ausgestaltet sein und kann beispielsweise einen Hauptkanal umfassen, durch welchen ein Hauptteil des fluiden Mediums strömt, sowie mindestens einen Bypasskanal, durch welchen ein aus dem Hauptkanal abgezweigter Volumenanteil und/oder Strömungsanteil des fluiden Mediums strömen kann. Das Sensorelement kann insbesondere in dem Strömungskanal angeordnet sein, insbesondere in dem Bypasskanal, beispielsweise indem eine Messoberfläche des Sensorelements, beispielsweise des Sensorchips, von dem fluiden Medium überströmt wird. Diesbezüglich kann grundsätzlich auf den oben genannten Stand der Technik verwiesen werden.

Unter einem Elektronik-Modul ist grundsätzlich eine modulare Einheit zu verstehen, welche mindestens eine elektronische Komponente umfasst, beispielsweise mindestens ein elektronisches Bauteil. Weiterhin kann das Elektronik-Modul ein oder mehrere Zuleitungen und/oder eine Leiterbahnstruktur umfassen. Unter einer Ansteuer- und Auswerteschaltung ist grundsätzlich eine beliebige elektrische und/oder elektronische Schaltung zu verstehen, welche eingerichtet ist, um das Sensorelement für eine Messung anzusteuern und/oder mindestens ein Messsignal des Sensorelements aufzunehmen. Beispielsweise kann es sich hierbei um eine Schaltung handeln, welche das Sensorelement mit mindestens einem Strom und/oder mindestens einer Spannung versorgt, welche für die Messung benötigt werden können. Alternativ oder zusätzlich kann die Ansteuer- und Auswerteschaltung jedoch auch mindestens einen Messsignalaufnehmer umfassen, mittels dessen mindestens ein Messsignal des Sensorelements erfasst werden kann. Darüber hinaus kann die Ansteuer- und Auswerteschaltung ein oder mehrere Elemente umfassen, welche beispielsweise einer Signalverarbeitung und/oder einer Signalvorverarbeitung dienen, so dass beispielsweise bereits in der Ansteuer- und Auswerteschaltung eine zumindest teilweise Verarbeitung der Messsignale, beispielsweise eine Digitalisierung der Messsignale, erfolgen kann. Die Ansteuer- und Auswerteschaltung kann dementsprechend ein oder mehrere elektronische Bauelemente umfassen, beispielsweise ein oder mehrere der Bauelemente der folgenden Gruppe: einen Verstärker, einen Analog-Digitalwandler, ein Speicherelement, eine Datenverarbeitungsvorrichtung, insbesondere einen Microcontroller. Auch Kombinationen der genannten und/oder anderer Elemente sind denkbar. Die Ansteuer- und Auswerteschaltung kann, wie auch das Sensorelement, beispielsweise in einem Steckfühler aufgenommen sein.

Das Elektronik-Modul umfasst, wie oben ausgeführt, mindestens einen Sensorträger. Bei diesem Sensorträger kann es sich beispielsweise um einen beliebigen Träger handeln, welcher eingerichtet ist, um das Sensorelement aufzunehmen. Beispielsweise kann es sich hierbei um einen Flügel handeln, welcher in den Strömungskanal hineinragt. Beispielsweise kann der Sensorträger mindestens eine abgerundete Anströmkante aufweisen, um die Strömung durch den Strömungskanal möglichst geringfügig zu beeinflussen. Das Sensorelement kann in dem Sensorträger aufgenommen sein oder kann ganz oder teilweise mit dem Sensorträger verbunden sein. Insbesondere kann der Sensorträger mindestens eine Vertiefung aufweisen, in welche das Sensorelement eingelassen ist, beispielsweise der Sensorchip, so dass vorzugsweise mindestens eine Messoberfläche des Sensorelements von dem fluiden Mediums überströmt wird. Beispielsweise kann diese Messoberfläche an einer Seitenfläche eines Flügels des Sensorträgers sein, welcher in das strömende Medium hineinragt.

Das Elektronik-Modul weist, wie oben ausgeführt, mindestens ein Trägerelement, insbesondere ein zumindest teilweise außerhalb des Strömungskanals angeordnetes Trägerelement, mit einem darauf aufgebrachten Schaltungsträger der Ansteuer- und Auswerteschaltung auf. Unter einem Trägerelement ist allgemein ein beliebiges Element zu verstehen, welches eingerichtet ist, um den Schaltungsträger zu tragen. Beispielsweise kann das Trägerelement mindestens ein plattenförmiges und/oder mindestens ein scheibenförmiges Element umfassen, also ein Element, dessen laterale Ausdehnung seine Dicke vorzugsweise um mindestens einen Faktor 5, insbesondere um mindestens einen Faktor 10 überschreitet. Weiterhin kann das Trägerelement ein oder mehrere Fixierelemente umfassen, beispielsweise Fixieröffnungen und/oder Rastelemente, um das Trägerelement in einem Gehäuse der Vorrichtung, beispielsweise in einem Steckfühlergehäuse, beispielsweise in einem Elektronikraum eines Steckfühlergehäuses, zu fixieren, der Gestalt, dass der Sensorträger in den Strömungskanal hineinragt. Beispielsweise können diese ein oder mehrere Fixierelemente auf einem hoch gezogenen, von einer Ebene des Trägerelements vorstehenden Rand des Trägerelements angeordnet sein und/oder auf einander gegenüberliegenden abgewinkelten Rändern des Trägerelements.

Unter einem Schaltungsträger ist allgemein im Rahmen der vorliegenden Erfindung ein Element zu verstehen, welches eine oder mehrere Schaltungsstrukturen, insbesondere ein oder mehrere Leiterbahnstrukturen, umfasst. Beispielsweise kann es sich bei diesem Schaltungsträger um eine Leiterplatte handeln, welche beispielsweise ganz oder teilweise aus einem Kunststoffmaterial und/oder ganz oder teilweise aus einem Keramikmaterial hergestellt sein kann und welche eine oder mehrere Leiterbahnen trägt. Darüber hinaus kann der Schaltungsträger weitere Elemente umfassen, beispielsweise ein oder mehrere Anschlusskontakte zur Verbindung des Schaltungsträgers mit dem Sensorelement und/oder zur Verbindung des Schalungsträgers mit externen Anschlüssen, beispielsweise Steckkontakten. Auf dem Schaltungsträger können beispielsweise eine oder mehrere elektrische und/oder elektronische Bauelemente der Ansteuer- und Auswerteschaltung aufgebracht sein, beispielsweise durch bekannte Bestückungstechniken.

Das Trägerelement weist auf der mindestens einen dem Schaltungsträger zuweisenden Oberfläche eine Mehrzahl von Vertiefungen auf. Unter einer dem Schaltungsträger zuweisenden Oberfläche ist insbesondere eine Oberfläche zwischen dem Trägerelement und dem Schaltungsträger zu verstehen, so dass beispielsweise der Schaltungsträger unmittelbar über der Oberfläche angeordnet ist, so dass beispielsweise eine senkrechte Projektion des Schaltungsträgers auf das Trägerelement vollständig oder teilweise auf der Oberfläche liegt. Die Oberfläche kann insbesondere eine ebene Oberfläche sein. Das Trägerelement kann insbesondere unmittelbar auf dieser Oberfläche aufliegen, beispielsweise auf einer oder mehreren Teilflächen, dieser Oberfläche, welche im Folgenden auch als Auflageflächen bezeichnet werden. Unter Vertiefungen sind Ausnehmungen in der Oberfläche zu verstehen, so dass die Oberfläche eine oder mehrere Teil-Oberflächen, insbesondere Auflageflächen, aufweist, welche erhaben ausgestaltet sind und welche von dem Trägerelement vorstehen, sowie eine oder mehrere dazwischen liegende Ausnehmungen, deren Oberfläche weiter im Inneren des Trägerelements angeordnet ist. Diese Vertiefungen können beispielsweise in einer Schnittebene senkrecht zu der Oberfläche einen abgerundeten, insbesondere kreisbogenförmigen, oder auch polygonalen Querschnitt aufweisen. Die erhabenen Flächen können beispielsweise derart ausgestaltet sein, dass der Schaltungsträger, insbesondere eine ebene Fläche des Schaltungsträgers, auf diesen aufliegen kann.

Der Schaltungsträger kann insbesondere mit dem Trägerelement durch mindestens eine stoffschlüssige Verbindung verbunden sein, insbesondere durch mindestens eine Verklebung zwischen der Oberfläche des Trägerelements und dem Schaltungsträger. Diese Verklebung kann insbesondere derart ausgestaltet sein, dass die Verklebung ausschließlich durch einen Klebstoff in den Vertiefungen erfolgt, während der Schaltungsträger weiterhin auf einer oder mehreren Auflageflächen des Trägerelements aufliegt. So können beispielsweise Bereiche des Trägerelements, insbesondere Auflageflächen, vorgesehen sein, welche direkt mit dem Schaltungsträger in Kontakt stehen, wohingegen beispielsweise andere Bereiche vorgesehen sind, in welchen die Verbindung über mindestens einen Klebstoff hergestellt wird.

Allgemein kann die Oberfläche, wie oben ausgeführt, insbesondere eine Mehrzahl von Auflageflächen aufweisen, wobei der Schaltungsträger auf den Auflageflächen aufliegt.

Zwischen den Auflageflächen können die Vertiefungen angeordnet sein. Ist eine Verklebung vorgesehen, so kann diese insbesondere ausschließlich über die Vertiefungen erfolgen, so dass beispielsweise die Vertiefungen ganz oder teilweise mit mindestens einem Klebstoff gefüllt sein können. Die Auflageflächen sind vorzugsweise Klebstoff-frei. Alternativ kann jedoch auch zwischen den Auflageflächen und dem Schaltungsträger mindestens ein Klebstoff, beispielsweise mindestens eine Klebstoffschicht, vorgesehen sein, welche jedoch vergleichsweise dünn ausgestaltet sein kann, beispielsweise mit einer Dicke von weniger als 1 mm, insbesondere mit einer Dicke von weniger als 0,5 mm.

Die Vertiefungen können, wie oben ausgeführt, zumindest teilweise mit mindestens einem Klebstoff gefüllt sein. Insbesondere können die Vertiefungen eine oder mehrere in die Oberfläche eingelassene Nuten umfassen, welche ganz oder teilweise mit einem Klebstoff gefüllt sein können.

Die Vertiefungen können in einer Richtung senkrecht zu der Oberfläche des Trägerelements insbesondere eine Tiefe von 0,1 mm bis 0,3 mm aufweisen, insbesondere eine Tiefe von nicht mehr als 0,25 mm, beispielsweise 0,1 mm bis 0,25 mm und besonders bevorzugt eine Tiefe von 0,2 mm bis 0,25 mm. Das Trägerelement kann beispielsweise eine Dicke von 0,4 mm bis 0,6 mm und insbesondere von 0,5 mm aufweisen. Auch andere Dicken sind jedoch möglich. Die Vertiefungen können eine gleichförmige Tiefe oder auch eine variierende Tiefe aufweisen.

In einer weiteren möglichen Ausgestaltung kann das Trägerelement insbesondere ganz oder teilweise aus mindestens einem Kunststoffmaterial hergestellt sein. Dieses Kunststoffmaterial kann beispielsweise mindestens einen thermoplastischen Kunststoff umfassen. Alternativ oder zusätzlich sind jedoch auch andere Kunststoffe einsetzbar. Das Trägerelement und der Sensorträger können insbesondere einstückig aus mindestens einem Kunststoffmaterial hergestellt sein. Beispielsweise können das Trägerelement und der Sensorträger aus demselben Kunststoffmaterial hergestellt sein. Die einstückige Herstellung kann insbesondere in einem Spritzgießverfahren oder einem anderen Kunststoff-Formgebungsverfahren erfolgen, beispielsweise durch Herstellung des Sensorträgers und des Trägerelements in ein und demselben Formnest. Das Kunststoffmaterial kann insbesondere mindestens ein Flüssigkristallpolymer (LCP, Liquid Cristal Polymer) aufweisen.

Das Trägerelement kann insbesondere an einem Übergang zu dem Sensorträger mindestens eine Aussparung aufweisen. Beispielsweise kann der Sensorträger als Flügel von einer ansonsten im Wesentlichen eben ausgestalteten Fläche des Trägerelements vorstehen, wobei am Übergang zwischen dieser ebenen Fläche, beispielsweise einer rechteckigen Fläche, die mindestens eine Aussparung vorgesehen sein kann.

Wie oben ausgeführt, kann das Sensorelement insbesondere in eine Vertiefung in dem Sensorträger eingelassen sein. Beispielsweise kann der Sensorträger einstückig mit dem Trägerelement hergestellt werden, beispielsweise einem Spritzgießverfahren, wobei die Vertiefung hergestellt wird. In diese Vertiefung kann anschließend das Sensorelement eingelassen sein. Die Vertiefung kann insbesondere derart ausgestaltet sein, dass eine Messoberfläche des Sensorelements von dem fluiden Medium in dem Strömungskanal überströmbar ist.

Das Sensorelement und die Ansteuer- und Auswerteschaltung können insbesondere durch mindestens eine Bonddrahtverbindung elektrisch miteinander verbunden sein. Insbesondere kann die Ansteuer- und Auswerteschaltung mindestens eine Kontaktpad aufweisen, beispielsweise auf einer Oberfläche des Schaltungsträgers, und auch das Sensorelement kann mindestens einen Kontaktpad aufweisen. Diese Kontaktpads können miteinander beispielsweise durch ein Dünndrahtbonding oder auch ein Dickdrahtbonding verbunden sein.

Allgemein kann das Trägerelement mindestens eine Oberflächenstruktur mit sich wiederholenden Struktureinheiten oder auch eine Oberflächenstruktur mit sich nicht wiederholenden Struktureinheiten aufweisen. Die Oberflächenstruktur kann beispielsweise die Vertiefungen bereitstellen. Die Oberflächenstruktur kann darüber hinaus jedoch auch eine regelmäßige oder unregelmäßige Oberflächenrauigkeit umfassen, beispielsweise eine Oberflächenrauigkeit RMS von 20 Mikrometern bis 100 Mikrometern, insbesondere von 30 Mikrometern bis 80 Mikrometern und besonders bevorzugt von 40 Mikrometern bis 60 Mikrometern. Die Oberflächenstruktur kann beispielsweise auf der dem Schaltungsträger zuweisenden Oberfläche oder auf Teilen dieser Oberfläche vorgesehen sein. Alternativ oder zusätzlich kann die Oberflächenstruktur jedoch auch in einem oder mehreren weiteren Bereichen des Trägerelements vorgesehen sein, beispielsweise auf dem Sensorträger oder Teilen desselben, insbesondere in einer Vertiefung zur Aufnahme des Sensorelements.

Die Oberflächenstruktur kann insbesondere ausgewählt sein aus der Gruppe bestehend aus den folgenden Oberflächenstrukturen: einem Linienmuster, insbesondere einem Gitter; einer Wabenstruktur mit erhabenen Wabenrändern; einer Wabenstruktur mit vertieften Wabenrändern; einer Noppenstruktur mit erhabenen Noppen; einer Noppenstruktur mit vertieften Noppen; einem Fischgrätenmuster mit erhabenen Fischgräten; ein Fischgrätenmuster mit vertieften Fischgräten; einer zufälligen Oberflächentextur ohne wiederkehrende Struktureinheiten; einer Golfballstruktur mit vertiefen Punkten; einer Golfball mit erhöhten Punkten; einer Stäbchenstruktur mit erhöhten Stäbchen; einer Stäbchenstruktur mit vertieften Stäbchen.

In einem weiteren Aspekt der vorliegenden Erfindung wird ein Verfahren zur Herstellung einer erfindungsgemäßen Vorrichtung in einer oder mehreren der vorangehend oder nachfolgend noch näher beschriebenen Ausgestaltungen vorgeschlagen. Das Verfahren wird derart durchgeführt, dass die Vertiefungen bei einem Formgebungsverfahren des Trägerelements in die Oberfläche eingebracht werden, insbesondere bei einem Kunststoff-Formgebungsverfahren und besonders bevorzugt bei einem Spritzgießverfahren.

Das Verfahren kann insbesondere derart durchgeführt werden, dass der Sensorträger und das Trägerelement bei dem Formgebungsverfahren einstückig hergestellt werden.

Das Verfahren kann weiterhin insbesondere derart durchgeführt werden, dass nach dem Formgebungsverfahren und vor dem Aufbringen des Schaltungsträgers das Trägerelement mindestens einem Oberflächenbehandlungsschritt unterzogen wird, beispielsweise einem Behandlungsschritt, bei welchem mindestens eine Spritzhaut von der Oberfläche des Trägerelements entfernt wird. Beispielsweise kann dieser Oberflächenbehandlungsschritt mindestens ein mechanisches Verfahren umfassen, beispielsweise ein Polierverfahren und/oder ein Bürstenverfahren und/oder ein Sandstrahlverfahren.

Die vorgeschlagenen Vorrichtung und das vorgeschlagene Verfahren weisen gegenüber bekannten Vorrichtungen und Verfahren der genannten Art eine Vielzahl von Vorteilen auf. Insbesondere kann eine Adhäsion zwischen dem Trägerelement, insbesondere einem Kunststoff-Trägerelement, und einem Klebstoff verbessert werden. So kann insbesondere beim Auftragen ein flüssiger oder pastöser Klebstoff in die Vertiefungen der Oberfläche, welche im Folgenden auch als Fügeteiloberfläche bezeichnet wird, geraten.

Nach einer Aushärtung wird dadurch beispielsweise eine mechanische Verklammerung aufgebaut, die zur Erhöhung der gesamten Klebefläche und zu einer günstigen Spannungsverteilung bei Belastung in einem Kontaktbereich führen kann. Dies kann eine erhöhte mechanische Adhäsion bedingen.

Vorzugsweise kann das üblicherweise als Trägerelement bei Heißfilmluftmassenmessern verwendete Bodenblech mit dem Sensorträger durch ein, in Form und Abmessungen vorzugsweise identisches, kostengünstiges Trägerelement in Form einer Kunststoffaufnahme ersetzt werden, beispielsweise auf Basis eines Flüssigkristallpolymers. Diese Kunststoffaufnahme kann als Träger für den Schaltungsträger dienen, beispielsweise für die bestückte Leiterplatte, und weiterhin als Träger für das eingesetzte, beispielsweise eingeklebte Sensorelement, beispielsweise dem Sensorchip, sowie optional für mindestens eine elektrische Verbindung, beispielsweise Bonddrähte, zwischen dem Sensorelement und dem Schaltungsträger. Da Flüssigkristallpolymer üblicherweise von einer hoch orientierten Spritzhaut umgeben ist, die die Oberfläche für die Verklebung darstellen kann, kann in bestimmten Fällen ein Entfernen dieser Spritzhaut erforderlich sein, um eine langzeitstabile Verbindung mit hoher Verbundfestigkeit zu erzielen. Um die mechanische Adhäsion weiter zu verbessern, kann eine langzeitstabile Verbindung mit hoher Verbundfestigkeit erzielt werden, indem die Oberfläche des Kunststoffs beispielsweise mit einer Oberflächentextur, beispielsweise gemäß der oben beschriebenen Art, ausgestattet wird. Die mindestens eine Vertiefung kann die gesamte Klebefläche erhöhen und kann zu einer Änderung in der Spannungsverteilung im Kontaktbereich bei Belastung der Klebeverbindung führen. Dabei lassen sich sowohl eine Klebehaftung des Schaltungsträgers, beispielsweise der Leiterplatte, und des Sensorchips, auf dem Trägerelement verbessern. Es können verschiedene Typen der Oberflächentexturen mit verschiedenem Rauhigkeitswert vorgesehen sein.

### Kurze Beschreibung der Zeichnungen

Weitere Einzelheiten und Merkmale der Erfindung ergeben sich aus der nachfolgenden Beschreibung bevorzugter Ausführungsbeispiele. Die Erfindung ist nicht auf die Ausführungsbeispiele beschränkt.

Es zeigen:
Figur 1 eine Explosionsdarstellung einer erfindungsgemäßen Vorrichtung zur Erfassung mindestens einer Eigenschaft eines strömenden fluiden Mediums;
Figuren 2A und 2B verschiedene Ansichten eins Trägerelements zum Einsatz in der Vorrichtung gemäß Figur 1; und
Figuren 3A bis 3F verschiedene Ausführungsbeispiele von Oberflächenstrukturen zum Einsatz in dem Trägerelement der Vorrichtung gemäß Figur 1.

### Ausführungsformen der Erfindung

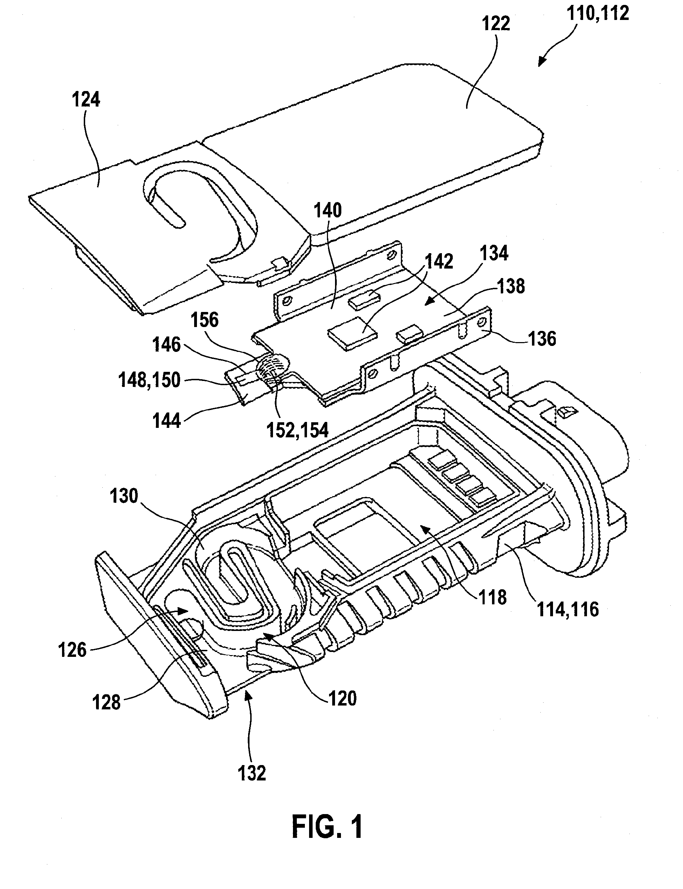

In Figur 1 ist ein erfindungsgemäßes Ausführungsbeispiel einer Vorrichtung 110 zur Erfassung mindestens einer Eigenschaft eines strömenden fluiden Mediums in einer perspektivischen Explosionsdarstellung gezeigt. Die Vorrichtung 110 ist in diesem Ausführungsbeispiel als Heißfilmluftmassenmesser 112 ausgestaltet, welcher einen Steckfühler 114 umfasst, der beispielsweise in ein Strömungsrohr eines Ansaugtrakts einer Brennkraftmaschine eingesteckt werden kann. Der Steckfühler 114 weist ein Steckfühlergehäuse 116 auf, mit einem Elektronikraum 118 und einem Messkanalraum 120, welche durch einen Elektronikraumdeckel 122 bzw. einen Messkanalraumdeckel 124 verschließbar sind. In dem Messkanalraum 122 ist ein Strömungskanal 126 vorgesehen, welcher in dem dargestellten Ausführungsbeispiel mehrteilig ausgestaltet ist und welcher einen Hauptkanal 128 und einen Bypasskanal 130 aufweist. Durch eine Einlassöffnung 132 kann fluides Medium, in diesem Fall beispielsweise Luft, in den Strömungskanal 126 einströmen und diesen durchströmen.

Weiterhin umfasst die Vorrichtung 110 ein Elektronik-Modul 134 mit einem Trägerelement 136. Dieses Trägerelement 136 wird, da dieses bei herkömmlichen Heißfilmluftmassenmessern üblicherweise als Stanz-Biege-Teil ausgestaltet ist, auch als Bodenblech bezeichnet. Im Rahmen der vorliegenden Erfindung ist es jedoch besonders bevorzugt, dieses Trägerelement 136 vollständig oder teilweise aus einem Kunststoffmaterial herzustellen, beispielsweise als Spritzgießbauteil. Auf dem Trägerelement 136 ist eine Ansteuer- und Auswerteschaltung 138 vorgesehen, welche beispielsweise einen Schaltungsträger 140 in Form einer Leiterplatte und/oder in Form eines anderen Schaltungsträgers umfassen kann, sowie eine oder mehrere auf diesem Schaltungsträger 140 aufgebrachte Elektronik-Komponenten 142. Weiterhin umfasst das Trägerelement 136 einen Sensorträger 144. Während der übrige Teil des Trägerelements 136 und der Schaltungsträger 140 vorzugsweise vollständig oder zumindest teilweise in dem Elektronikraum 118 angeordnet sind, ragt der Sensorträger 144 in den Strömungskanal 126 hinein, beispielsweise in den Bypasskanal 130.

Während bei vielen üblichen Vorrichtungen 110 der gezeigten Art der Sensorträger 144 beispielsweise als Spritzgussbauteil ausgestaltet ist, welches an ein Bodenblech des Trägerelements 136 angespritzt ist, ist es im Rahmen der vorliegenden Ausgestaltung bevorzugt, wenn der Sensorträger 144 und der restliche Teil des Trägerelements 136 ein gemeinsames Bauteil bilden, beispielsweise ein einstückiges Bauteil, beispielsweise eine gemeinsame Kunststoffaufnahme, welche vorzugsweise in einem einzigen Spritzgussvorgang oder einer anderen Art von Kunststoff-Formgebungsverfahren hergestellt werden kann. Auf dieses Trägerelement 136 kann dann, wie in den Figuren dargestellt, die Ansteuer- und Auswerteschaltung 138 aufgebracht werden, beispielsweise indem der Schaltungsträger 140, wie unten noch näher erläutert wird, auf das Trägerelement 136 aufgeklebt wird.

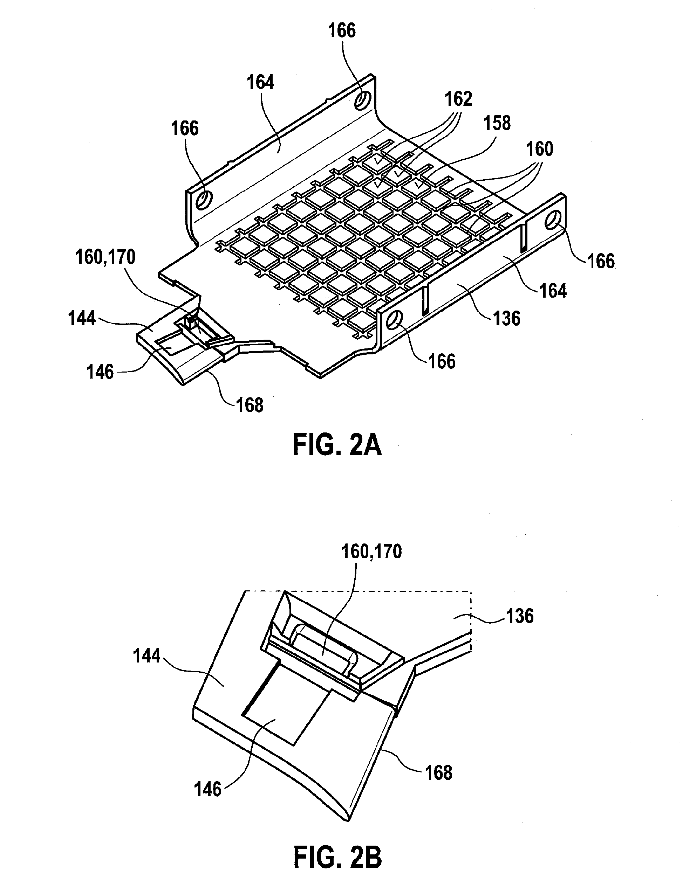

In dem Sensorträger 144 kann in einer Vertiefung 146 (siehe hierzu auch die nachfolgend beschriebenen Figuren 2A und 2B) ein Sensorelement 148, beispielsweise in Form eines Sensorchips 150 und vorzugsweise in Form eines Heißfilmluftmassenmesser-Chips eingebracht sein. Der Heißfilmluftmassenmesser-Sensorchip kann beispielsweise als Silicium-Chip mit einer Messoberfläche mit mindestens einem Heizelement und mindestens zwei Temperaturfühlern ausgestaltet sein, was in den Figuren nicht dargestellt ist. Bezüglich der Wirkungsweise dieses Sensorchips 150 kann beispielsweise auf den oben beschriebenen Stand der Technik verwiesen werden. Das Sensorelement 148 kann beispielsweise mit dem Sensorträger 144 durch eine Verklebung verbunden werden. Das Sensorelement 148 und die Ansteuer- und Auswerteschaltung 138 können beispielsweise über eine elektrische Verbindung 152 miteinander verbunden werden. Beispielsweise kann es sich hierbei um ein Dünndraht-Bonding mit einem oder mehreren dünnen Drähten handeln. Bei der Herstellung der Vorrichtung 110 kann beispielsweise in die Vertiefung 146 des Sensorträgers 144 des Trägerelements 136 der Sensorchip 150 eingebracht und beispielsweise eingeklebt werden. Anschließend kann die elektrische Verbindung 152 hergestellt werden, beispielsweise in Form einer Drahtverbindung 154, beispielsweise einer Bondverbindung. Diese Drahtverbindung kann sich beispielsweise zwischen dem Sensorchip 150 und der Ansteuer- und Auswerteschaltung 138 erstrecken. Optional kann die elektrische Verbindung 152 ganz oder teilweise durch mindestens ein passivierende Material und/oder Abdeckmaterial 156 geschützt werden, beispielsweise durch einen so genannten Glob Top.

In den Figuren 2A und 2B sind Detaildarstellungen möglicher Ausgestaltungen des Trägerelements 136 dargestellt. Wie sich insbesondere aus Figur 2A ergibt, weist das Trägerelement 136, welches vorzugsweise als Kunststoffbauteil ausgestaltet ist, eine dem Schaltungsträger 140 (in den Figuren 2A und 2B nicht dargestellt) Oberfläche 158 auf, welche beispielsweise im Wesentlichen eben ausgestaltet sein kann. Diese Oberfläche 158 kann beispielsweise eine Kunststoffoberfläche sein. Auf diese Oberfläche 158, welche auch als Montageoberfläche bezeichnet werden kann, weist eine Mehrzahl von Vertiefungen 160 auf. Diese Vertiefungen können beispielsweise in Form eines Gitters angeordnet sein, wie in Figur 2A erkennbar. Diese Vertiefungen können beispielsweise eine Mehrzahl von Auflageflächen 162 umgeben, welche exemplarisch in Figur 2A als rechteckige oder quadratische Auflageflächen ausgestaltet sind. Auch andere Ausgestaltungen sind möglich. Die Vertiefungen 160 in Figur 2A können beispielsweise, ausgehend von den Auflageflächen 162, in diesem oder auch in allen andren Ausführungsbeispielen der vorliegenden Erfindung eine Tiefe von 0,1 mm bis 0,3 mm aufweisen, insbesondere ein Tiefe von 0,1 mm bis 0,25 mm und besonders bevorzugt eine Tiefe von 0,2 mm bis 0,25 mm. Das Trägerelement 136 kann beispielsweise eine Dicke von 0,5 mm aufweisen. Die Vertiefungen 160 können beispielsweise als Nuten ausgestaltet sein, beispielsweise mit einem eckigen oder abgerundeten Querschnitt, beispielsweise einem runden oder halbrunden Querschnitt.

Weiterhin kann das Trägerelement 136, wie in Figur 2A erkennbar, ein oder mehrere Befestigungselemente 164 umfassen, beispielsweise in Form von hochgezogenen Rändern mit einer oder mehreren Öffnungen 166, beispielsweise zur Befestigung in dem Steckfühlergehäuse 116. Diese Befestigungselemente 164 können beispielsweise einstückig mit dem übrigen Teil des Trägerelements 136 ausgestaltet sein.

Weiterhin ist in den Figuren 2A und 2B auch der Sensorträger 144 erkennbar, welcher vorzugsweise ebenfalls einstückig mit dem übrigen Trägerelement 136 ausgebildet ist, beispielsweise als einstückiges Kunststoffbauteil. Dieser Sensorträger 144 kann beispielweise flügelartig ausgestaltet sein und/oder kann mindestens eine Anströmkante 168 aufweisen, welche beispielsweise in dem Bypasskanal 130 einer Hauptströmungsrichtung des strömenden fluiden Mediums entgegen weisen kann.

Weiterhin kann der Sensorträger, wie in den Figuren 2A und 2B erkennbar, am Übergang zwischen der Vertiefung 146 zur Aufnahme des Sensorelements 148 und der Oberfläche 158 mindestens eine Aussparung 170 aufweisen. Auch diese Aussparung 170 kann als Bestandteil der Vertiefungen 160 angesehen werden. Diese Aussparung 170 kann beispielsweise bei der Montage zur Aufnahme von Klebstoff dienen.

Die in Figur 2A erkennbaren Vertiefungen 160 in der Auflagefläche 162, beispielsweise in Form eines Gitters, können die gesamte Klebefläche vergrößern und zur Änderung in einer Spannungsverteilung in einem Kontaktbereich bei einer Belastung einer Klebeverbindung zwischen dem Trägerelement 136 und dem Schaltungsträger 140 dienen.

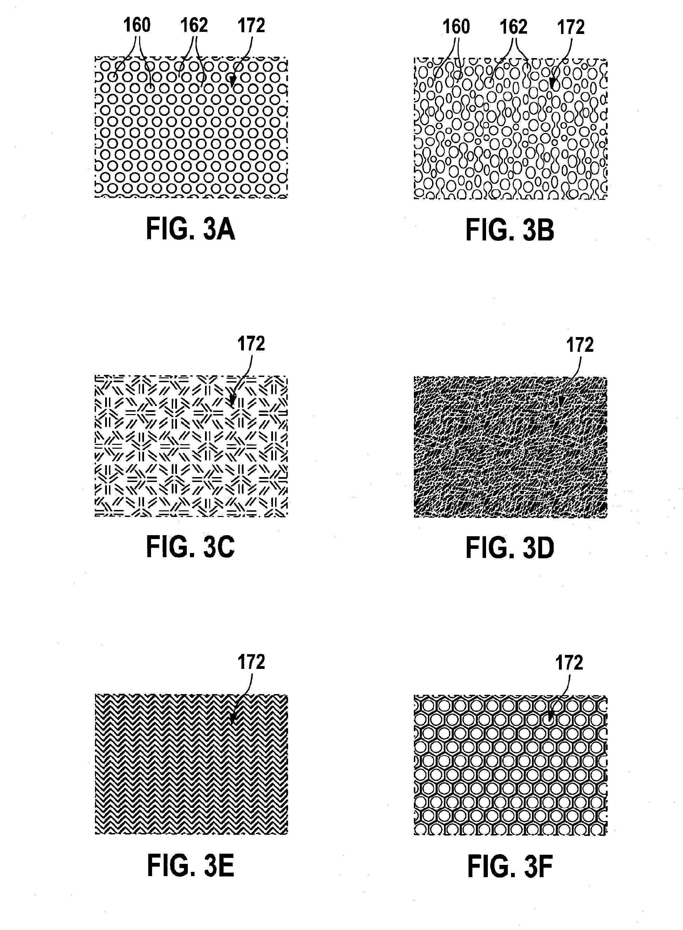

Weiterhin kann das gesamte Trägerelement 136 oder Teile desselben eine Oberflächenstruktur 172 aufweisen. Dies ist exemplarisch in den Figuren 3A bis 3F gezeigt. Unter einer Oberflächenstruktur ist allgemein eine Struktur zu verstehen, welche eine Gesamtoberfläche gegenüber einer glatten Oberfläche vergrößert. Insbesondere können Rauigkeiten mit Erhebungen und Vertiefungen vorgesehen sein, wobei die Rauigkeiten, beispielsweise mittlere Rauigkeiten, in diesem oder auch in allen anderen Ausführungsbeispielen optional eine RMS-Rauigkeit von 20 pm bis 100 pm, insbesondere von 40 µm bis 60 µm, aufweisen können. Die Oberflächenstruktur, welche auch als Oberflächentextur bezeichnet werden kann, kann ihrerseits wiederum Auflageflächen 162 und Vertiefungen 160 umfassen. So können die Auflageflächen 162 beispielsweise von Vertiefungen 160 umgeben sein oder umgekehrt. Dies ist in den Figuren 3A bis 3F exemplarisch am Beispiel der Figuren 3A und 3B gezeigt. So zeigt Figur 3A eine Golfballstruktur mit punktförmigen oder kreisförmigen Vertiefungen 160, welche von Auflageflächen 162 umgeben sind. Die Vertiefungen 160 können beispielsweise in einer Matrix angeordnet sein. In Figur 3B sind gegen eine Oberflächentextur in Form einer Noppenstruktur gezeigt. Figur 3C zeigt eine Stäbchenstruktur mit sich wiederholenden Struktureinheiten. Figur 3D zeigt eine zufällige Oberflächenstruktur, wie sie üblicherweise im Bereich der Kunstlederherstellung verwendet wird. Figur 3E zeigt eine Fischgrätenstruktur mit erhabenen Fischgräten, wobei jedoch auch Fischgrätenstrukturen mit vertieften Fischgräten möglich sind. Zwischen den Fischgräten sind in diesem Ausführungsbeispiel die Vertiefungen ausgebildet, welche nicht näher bezeichnet sind. Figur 3F zeigt eine Wabenstruktur mit vertieften Waben, wobei jedoch auch Wabenstrukturen mit erhabenen Waben möglich sind. Die dargestellten Beispiele stellen lediglich eine Auswahl einer Vielzahl von Beispielen dar, um die Oberfläche 158 des Trägerelements 136 mit einer Mehrzahl von Vertiefungen 160 auszugestalten. Auch in anderen Bereichen des Trägerelements 136 können entsprechende Oberflächenstrukturen 172 vorgesehen sein, beispielsweise im Bereich der Vertiefung 146 zur Aufnahme des Sensorelements 148. Die Oberflächenstrukturen 172 und/oder die Vertiefungen 160 können somit allgemein eine stoffschlüssige Verbindung zwischen dem Trägerelement 136 und weiteren Bauteilen, beispielsweise dem Schaltungsträger 140 und/oder dem Sensorelement 148, verbessern.

## Patentansprüche

1. Vorrichtung (110) zur Erfassung mindestens einer Eigenschaft eines strömenden fluiden Mediums, umfassend mindestens einen von dem fluiden Medium durchströmbaren Strömungskanal (126), weiterhin umfassend mindestens ein Elektronik-Modul (134) mit mindestens einer Ansteuer- und Auswerteschaltung (138), wobei das Elektronik-Modul (134) mindestens einen in den Strömungskanal (126) ragenden Sensorträger (144) mit mindestens einem Sensorelement (148) zur Erfassung der Eigenschaft aufweist, wobei das Elektronik-Modul (134) mindestens ein Trägerelement (136) mit mindestens einem darauf aufgebrachten Schaltungsträger (140) der Ansteuer- und Auswerteschaltung (138) aufweist, **dadurch gekennzeichnet, dass**
das Trägerelement (136) auf mindestens einer dem Schaltungsträger (140) zuweisenden Oberfläche (158) eine Mehrzahl von Vertiefungen (160) aufweist.

2. Vorrichtung (110) nach dem vorhergehenden Anspruch, wobei der Schaltungsträger (140) mit dem Trägerelement (136) durch mindestens eine stoffschlüssige Verbindung verbunden ist, insbesondere eine Verklebung zwischen der Oberfläche (158) des Trägerelements (136) und dem Schaltungsträger (140).

3. Vorrichtung (110) nach einem der vorhergehenden Ansprüche, wobei die Oberfläche (158) eine Mehrzahl von Auflageflächen (162) aufweist, wobei das Trägerelement (136) auf den Auflageflächen (162) aufliegt, wobei zwischen den Auflageflächen (162) die Vertiefungen (160) angeordnet sind.

4. Vorrichtung (110) nach einem der vorhergehenden Ansprüche, wobei die Vertiefungen (160) zumindest teilweise mit mindestens einem Klebstoff gefüllt sind.

5. Vorrichtung (110) nach einem der vorhergehenden Ansprüche, wobei das Trägerelement (136) aus mindestens einem Kunststoffmaterial hergestellt ist, wobei das Trägerelement (136) und der Sensorträger (144) einstückig aus dem mindestens einem Kunststoffmaterial hergestellt sind.

6. Vorrichtung (110) nach einem der beiden vorhergehenden Ansprüche, wobei das Kunststoffmaterial mindestens ein Flüssigkristallpolymer aufweist.

7. Vorrichtung (110) nach einem der vorhergehenden Ansprüche, wobei das Trägerelement (136) an einem Übergang zu dem Sensorträger (144) mindestens eine Aussparung (170) aufweist.

8. Vorrichtung (110) nach einem der vorhergehenden Ansprüche, wobei die das Trägerelement (136) eine Oberflächenstruktur (172) umfasst, insbesondere eine Oberflächenstruktur (172) mit sich wiederholenden Struktureinheiten.

9. Verfahren zur Herstellung einer Vorrichtung (110) nach einem der vorhergehenden Ansprüche, wobei die Vertiefungen (160) bei einem Formgebungsverfahren des Trägerelements (136) in die Oberfläche (158) eingebracht werden, insbesondere bei einem Kunststoffformgebungsverfahren und besonders bevorzugt bei einem Spritzgießverfahren.

10. Verfahren nach einem der beiden vorhergehenden Ansprüche, wobei das Trägerelement (136) nach dem Formgebungsverfahren und vor dem Aufbringen des Schaltungsträgers (140) mindestens einem Oberflächenbehandlungsschritt unterzogen wird, vorzugsweise einem Behandlungsschritt, bei welchem mindestens eine Spritzhaut von der Oberfläche (158) entfernt wird.
